# FASCICULE DE BREVET EUROPEEN

(11) **EP 0 681 746 B1**
(45) Date de publication et mention de la délivrance du brevet: **15.10.1997**
(21) Numéro de dépôt: 94904220.4
(22) Date de dépôt: 11.01.1994
(51) Int. Cl.: H01L 41/09

(54) **COMPOSANT PIEZOELECTRIQUE ET PROCEDE DE SA FABRICATION**
PIEZOELEKTRISCHES BAUELEMENT UND VERFAHREN ZU SEINER HERSTELLUNG
PIEZOELECTRIC COMPONENT AND METHOD FOR THE PRODUCTION THEREOF

(30) Priorité: 29.01.1993 FR 9300949
(43) Date de publication de la demande: 15.11.1995
(73) Titulaire: THOMSON-CSF, 75008 Paris (FR)
(72) Inventeur: FERAL, Thierry, F-92402 Courbevoie Cédex (FR); FROMONT, Bernard, F-92402 Courbevoie Cédex (FR); STEPHAN, Ronan, F-92402 Courbevoie Cédex (FR); SERNIT, Eric, F-92402 Courbevoie Cédex (FR); LACOUR, Olivier, F-92402 Courbevoie Cédex (FR)
(74) Mandataire: Guérin, Michel
(86) Numéro de dépôt international: FR9400031
(87) Numéro de publication internationale: WO9417562

(56) Documents cités:
- EP-A- 0 190 574

## Description

La présente invention concerne un procédé de fabrication de composant piézoélectrique ainsi que le composant issu d'un tel procédé.

Les composants piézoélectriques sont utilisés, entre autre, dans le domaine de l'acoustique. Ils participent alors à l'équipement de haut-parleurs, de microphones ou encore d'hydrophones.

L'application décrite dans la présente demande concerne plus particulièrement les capteurs acoustiques utilisés pour la détection sous-marine et, notamment, les capteurs utilisés dans les antennes linéaires remorquées.

L'invention concerne cependant tous les domaines d'application utilisant des composants piézoélectriques.

Les capteurs acoustiques utilisés dans les antennes linéaires remorquées sont généralement constitués d'une pièce diélectrique piézoélectrique sur laquelle sont collées deux électrodes métalliques.

I,a différence de potentiel qui apparaît aux bornes des deux électrodes est alors une fonction de la différence des pressions qui s'exercent sur elles.

Afin de rendre le capteur insensible à l'accélération, il est connu de l'homme de l'art que le capteur est constitué de deux pièces diélectriques piézoélectriques dont les sens de polarisation sont opposés.

Le capteur ainsi constitué est alors monté dans un boîtier de façon à protéger les pièces piézoélectriques des agents chimiques, par exemple l'huile, qui environnent le composant dans le montage final.

La fabrication d'un tel capteur présente de nombreux inconvénients. L'usinage des pièces piézoélectriques est difficile. En effet, les diélectriques utilisés sont fragiles et de nombreuses pièces peuvent se casser lors des manipulations.

D'autre part, l'assemblage des pièces piézoélectriques et des électrodes métalliques s'effectue par collage, en empilant, à plat, les pièces mécaniques les unes sur les autres, ce qui constitue une intervention longue et fastidieuse.

Enfin, la mise en boîtier oblige à une intervention supplémentaire. Ce procédé de fabrication nécessite donc des interventions délicates assez longues conduisant à un coût élevé.

L'invention ne présente pas ces inconvénients.

Il est connu aussi la fabrication de composants piézoélectriques par laminage tels que ceux décrits dans le brevet européen EP - A - 0 190574.

L'invention a pour objet un procédé de fabrication de composant piézoélectrique selon la revendication 1.

L'invention a aussi pour objet le composant piézoélectrique issu d'un tel procédé selon la revendication 8.

Un avantage de l'invention est donc de simplifier le procédé de fabrication des composants piézoélectriques.

D'autres caractéristiques et avantages de l'invention apparaîtront à la lecture d'un mode de réalisation préférentiel fait avec référence aux figures ci-annexées dans lesquelles :
- la figure 1 représente la vue en coupe d'un composant piézoélectrique selon l'invention ;
- la figure 2 représente la vue schématique d'une machine permettant la fabrication de composants piézoélectriques selon le mode de réalisation préférentiel de l'invention.

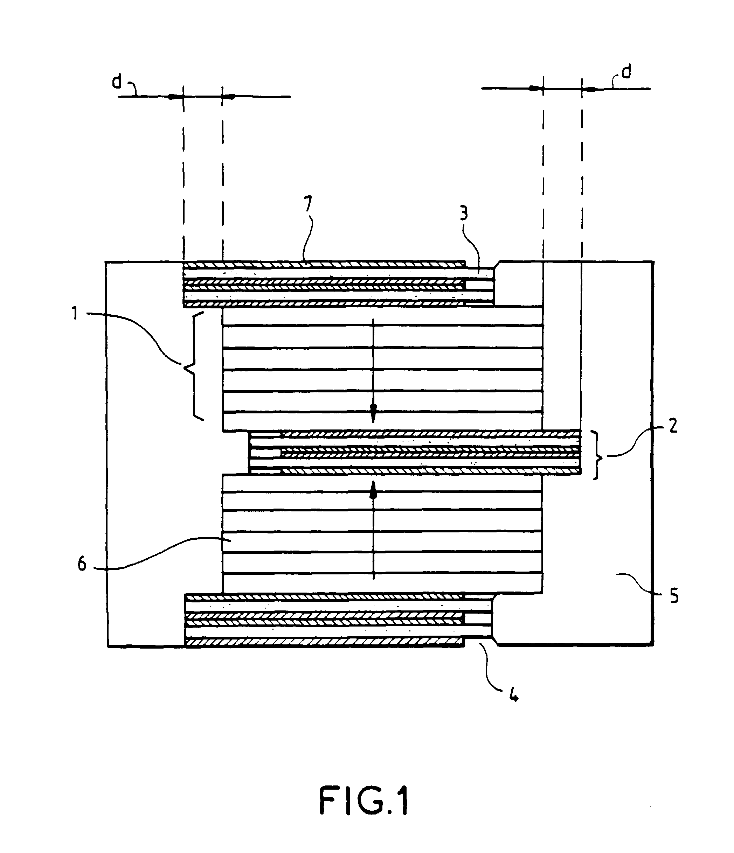

La figure 1 est une vue en coupe d'un composant piézoélectrique selon l'invention.

Ce composant est de type empilé mais l'invention concerne aussi les composants de type bobiné. Pour des raisons de commodité, le composant représenté en figure 1 n'est constitué que de 2 éléments piézoélectriques 1 enserrant une électrode métallique 2, lesdits éléments piézoélectriques 1 étant eux-mêmes intercalés entre 2 électrodes métalliques 2.

De façon générale les éléments piézoélectriques sont au nombre de n (n étant un nombre entier supérieur ou égal à 1) et sont intercalés de façon régulière entre n+1 électrodes métallisées 2. Selon le mode de réalisation préférentiel de l'invention n = 10. Comme cela est représenté sur la figure 1, deux électrodes successives 2 enserrent un élément diélectrique et chacune des deux électrodes 2 présente un débordement d par rapport à l'élément diélectrique, le débordement présenté par l'une étant à l'opposé du débordement présenté par l'autre. De façon générale, les électrodes 2 sont ainsi régulièrement décalées les unes par rapport aux autres. Toutes les électrodes situées sur un même côté sont alors reliées par une même armature métallique 5.

Chaque élément piézoélectrique 1 est constitué d'un ensemble de p feuilles diélectriques piézoélectriques 6, ou p est un nombre entier, par exemple égal à 40. Pour des raisons de commodité la figure 1 représente une configuration pour laquelle p = 6.

Le matériau constituant les feuilles 6 est du polyfluorure de vinylidène (PVDF) ou un copolymère constitué dudit polyfluorure de vinylidène et de trifluoroéthylène (TrFE).

Ces polymères ou copolymères ferroélectriques présentent de nombreux avantages par rapport aux céramiques usuelles. D'une part, ils présentent les avantages des élastomères (flexibilité, possibilité de réaliser de grandes surfaces) et, d'autre part, ils ont des propriétés piézoélectriques en mode hydrostatique largement supérieures à celles desdites céramiques. De plus, leur impédance mécanique est plus proche de celle de l'eau, ce qui présente des avantages pour les applications sous-marines et biologiques.

Afin de présenter une activité piézoélectrique, les polymères mentionnés ci-dessus doivent être polarisés par un champ électrique. Le champ électrique doit alors prendre des valeurs d'autant plus élevées que l'épaisseur du polymère est importante.

Selon l'invention, les feuilles diélectriques 6 choisies ont une épaisseur relativement faible, comprise entre quelques microns et 50 microns. Selon le mode de réalisation préférentiel leur épaisseur est égale à 25 microns. Avantageusement, la polarisation est alors effectuée, par exemple par effet CORONA, directement en sortie de l'extrudeuse mettant en forme les feuille diélectriques.

Sur le composant final, les éléments piézoélectriques 1 peuvent être tous polarisés dans le même sens. Ils peuvent aussi être pour moitié polarisés dans un sens et pour moitié dans un sens opposé comme cela est représenté symboliquement sur la figure 1 à l'aide de flèches. Cette inversion de polarisation est nécessaire dans le cas où on désire que le composant soit insensible aux accélérations qu'il est susceptible de subir lors de son utilisation.

Les électrodes métallisées 2 sont constituées soit de feuilles entièrement métallisées, par exemple des feuilles d'aluminium, soit de feuilles diélectriques 3 recouvertes de métallisations 7 sur au moins une de leurs faces, comme cela est représenté en figure 1. Le matériau constituant les feuilles diélectriques 3 est choisi parmi des matériaux tels que le polyester, le polycarbonate, le polysulfone, le polypropylène ou tout autre matériau similaire. La métallisation des feuilles diélectriques est, par exemple, réalisée par un procédé d'évaporation sous vide ou tout autre procédé connu de l'homme de l'art. La métallisation 7 est, par exemple, en aluminium, en zinc ou en alliage d'aluminium et de zinc.

Le nombre q de feuilles 3 constituant chaque électrode métallisée 2 est au moins égal à 1.

Chaque feuille diélectrique 3 présente sur un de ses deux bords une marge latérale non métallisée 4. Cette marge est nécessaire afin d'éviter que la métallisation 7 ne mette en court-circuit les 2 armatures 5 en regard.

Ce sont les extrémités entièrement métallisées des feuilles 3 qui assurent le débordement d mentionné précédemment. Les marges latérales 4 de deux électrodes successives 2 se trouvent alors sur des côtés opposés permettant de définir successivement des électrodes à marge droite et des électrodes à marge gauche.

Selon l'invention, l'empilement des différentes feuilles constituant le composant piézoélectrique est réalisé par enroulements successifs, sur une roue de grand diamètre, de films piézoélectriques et de films métallisés préalablement découpés à la largeur que doit présenter le composant.

Ainsi les étapes successives du procédé selon l'invention peuvent-elles s'énoncer comme suit afin de réaliser, par exemple, un composant comprenant deux éléments diélectriques et trois électrodes ;
- bobinage d'un premier film métallisé suivant un nombre de tours égal à q, ledit film métallisé permettant de constituer une électrode 2, par exemple, à marge droite.
- bobinage d'un premier film piézoélectrique suivant un nombre de tours égal à p, ledit film permettant de constituer un élément piézoélectrique 1 dont la polarisation est dans un premier sens.
- bobinage d'un second film métallisé suivant un nombre de tous égal à q, ledit film métallisé permettant de constituer une électrode 2, par exemple, à marge gauche.
- bobinage d'un second film piézoélectrique suivant un nombre de tours égal à p, ledit film permettant de constituer un élément piézoélectrique 1 dont la polarisation est dans un deuxième sens, opposé audit premier sens.
- bobinage du premier film métallisé suivant un nombre de tour égal à q, ledit film métallisé permettant de constituer une électrode 2, par exemple, à marge droite.

De façon générale, le nombre de bobinages successifs peut varier. En effet, comme cela a été mentionné précédemment, l'invention concerne un composant comportant n éléments piézoélectriques 1 et n+1 électrodes métalliques 2.

Le nombre n d'éléments piézoélectriques est choisi de façon à atteindre l'épaisseur voulue e du composant.

Un avantage de l'invention consiste donc à pouvoir réaliser facilement des composants d'épaisseur e variable.

L'épaisseur de l'élément piézoélectrique joue un rôle important dans la conception du composant. En effet, la sensibilité Sh d'un composant piézoélectrique, donnée par le rapport entre la tension délivrée par le composant et la pression exercée sur celui-ci, est d'autant meilleure que son épaisseur e est élevée. Or, comme cela a été mentionné précédemment, il est d'autant plus difficile de polariser un diélectrique que son épaisseur est élevée.

Ainsi, le fait de polariser le film diélectrique avant bobinage, sur une faible épaisseur, est-il un avantage du procédé selon l'invention puisque cela permet de réaliser facilement des composants de sensibilité élevée dont l'épaisseur ne pourrait que très difficilement être atteinte si la polarisation était effectuée sur le composant final. A titre d'exemple, le procédé selon l'invention permet d'obtenir des capteurs acoustiques dont la sensibilité hydrophonique est de l'ordre de moins 200 dB (référence 1 volt par micro Pascal).

Selon le mode de réalisation préférentiel, la polarisation du diélectrique est effectuée avant bobinage des films, quelle que soit l'épaisseur du composant final. Cependant, l'invention concerne aussi un procédé ou la polarisation est effectuée sur le composant final dans la mesure où l'épaisseur dudit composant le permet.

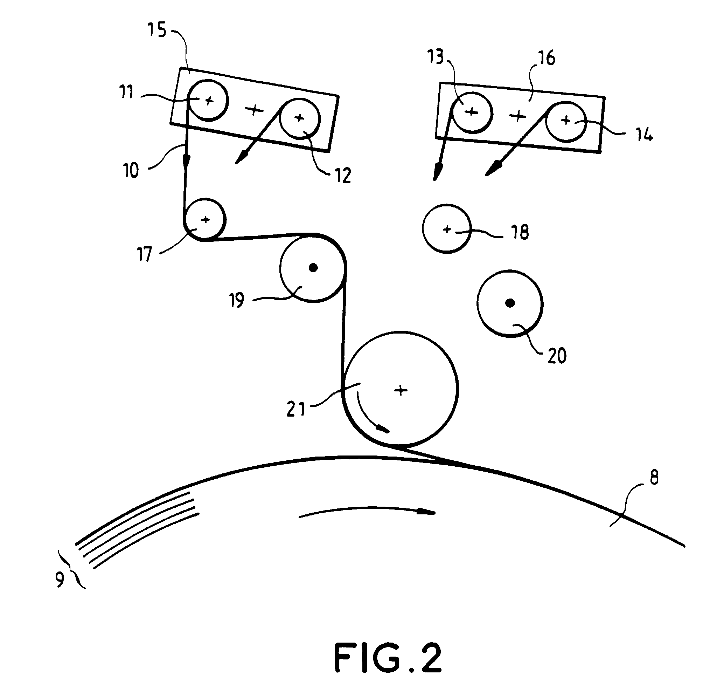

La figure 2 représente la vue schématique d'une machine permettant de réaliser les bobinages mentionnés ci-dessus.

Cette machine comporte une roue de grand diamètre 8 sur laquelle est bobiné un ruban 9. Un premier dévidoir 15 contient les films diélectriques métallisés destinés à constituer les électrodes 2. Ces films sont enroulés sous forme de deux galettes dont l'une, par exemple la galette 11, contient le film destiné à constituer les électrodes dites à marge droite et dont l'autre, par exemple la galette 12, contient le film destiné à constituer les électrodes dites à marge gauche.

Un second dévidoir 16 contient les films diélectriques piézoélectriques destinés à constituer les éléments piézoélectriques 1. Ces films sont aussi enroulés sous forme de galettes dont l'une, par exemple la galette 13, contient le film destiné à constituer un élément 1 dont la polarisation est dans un premier sens et dont l'autre, par exemple la galette 14, contient le film destiné à constituer un élément 1 dont la polarisation est dans un deuxième sens, opposé audit premier sens.

Les films métalliques et diélectriques sont enroulés successivement comme cela a été indiqué précédemment. Ils sont guidés par l'intermédiaire des galets respectifs 19 et 20.

Ce sont ces moyens de positionnement qui permettent d'assurer le débordement d mentionné précédemment. Une fois positionnés, les films passent par une roue de guidage 21 avant d'être amenés sur la roue 8.

A l'issue de cette étape d'enroulements est ainsi constitué un ruban d'épaisseur déterminée.

On procède ensuite au recouvrement des faces latérales de ce ruban par un métal ou un alliage conducteur de façon à constituer les futures armatures 5 des composants piézoélectriques. Ainsi une armature 5 peut-elle être constituée, par exemple, d'une première couche d'aluminium sur laquelle sont déposées successivement une couche de cuivre et une couche d'étain.

Le ruban ainsi métallisé sur ses faces latérales est alors stabilisé thermiquement sous contraintes, de manière à assurer sa rigidité mécanique.

On procède ensuite à la découpe du ruban en blocs unitaires, chaque bloc constituant un composant piézoélectrique.

Si cela s'avère nécessaire, on rapporte alors sur les armatures 5 du composant des connexions d'interface, par exemple des rubans ou des fils, par tout moyen connu de l'homme de l'art.

Dans le cas des antennes linéaires remorquées, il a été mentionné précédemment que des agents chimiques, par exemple de l'huile, constituent l'environnement des capteurs acoustiques. Selon l'art antérieur, il est nécessaire de protéger le composant de ces agents chimiques par une mise en boîtier.

Le matériau piézoélectrique utilisé selon l'invention (PVDF ou PVDF/TrFE) n'est pas sensible auxdits agents chimiques. Un autre avantage de l'invention consiste donc en ce que la mise en boîtier du composant n'est pas nécessaire. Il est alors possible, par exemple, de câbler directement le capteur sur le circuit électronique qui a pour fonction d'amplifier la tension délivrée par le composant.

Quand cela s'avère nécessaire la protection du composant peut tout de même être réalisée par encapsulation ou par tout moyen connu de l'homme de l'art.

Le mode de réalisation préférentiel de l'invention décrit ci-dessus concerne les composants de type empilé. Cependant, l'invention concerne aussi les composants de type bobiné. Les films diélectriques et métalliques sont alors bobinés sur des diamètres de faibles valeurs, par exemple 1 millimètre. Chaque bobinage constitue alors un composant piézoélectrique de type bobiné.

Selon le mode de réalisation préférentiel de l'invention, les électrodes 2 sont constituées séparément des éléments diélectriques 1.

L'invention concerne aussi des composants dont la fabrication est réalisée par l'enroulement de deux films diélectriques piézoélectriques préalablement métallisés.

Les deux films sont alors enroulés sur la roue de grand diamètre en présentant un décalage l'un par rapport à l'autre. Chacun des deux films présente une marge non métallisée sur l'un de ses bords de façon à éviter les court-circuits qui, sans cela, pourraient apparaître lors de la métallisation des faces latérales du ruban constitué par l'empilement.

## Revendications

1. Procédé de fabrication de composant piézoélectrique constitué de l'empilement d'au moins un élément piézoélectrique (1) et d'au moins deux électrodes métalliques (2), chaque élément piézoélectrique (1) se trouvant inséré entre deux électrodes métalliques (2), caractérisé en ce qu'il comprend n étapes de bobinage d'un film piézoélectrique suivant à chaque étape un nombre de tours égal à p et n + 1 étapes de bobinage d'un film métallique suivant à chaque étape un nombre de tours égal à q, n, p et q étant des nombres entiers supérieurs ou égaux à 1, chaque étape de bobinage de film piézoélectrique permettant de réaliser un élément piézoélectrique (1) et chaque étape de bobinage de film permettant de réaliser une électrode métallique (2), chaque bobinage de film métallique étant effectué de façon que chaque électrode métallique présente un débordement (d) par rapport à l'élément piézoélectrique (1) qu'elle jouxte, les débordements (d) de deux électrodes métalliques (2) insérant un même élément piézoélectrique (1) étant situés sur des côtés opposés.

2. Procédé selon la revendication 1, caractérisé en ce que les faces latérales des empilements réalisés par lesdits bobinages sont recouvertes par un métal ou un alliage conducteur de façon à constituer les armatures (5) des composants piézoélectriques.

3. Procédé selon la revendication 2, caractérisé en ce que le bobinage des films piézoélectriques (13, 14) et des films métallisés (11, 12) est effectué sur une roue de façon à constituer un ruban et en ce que le ruban est découpé en blocs unitaires constituant chacun un composant piézoélectrique de type empilé.

4. Procédé selon la revendication 2, caractérisé en ce que le bobinage des films piézoélectriques (13, 14) et des films métallisés (11, 12) constitue un composant piézoélectrique de type bobiné.

5. Procédé selon la revendication 3 ou 4, caractérisé en ce que deux bobinages piézoélectriques (1) successifs sont réalisés, l'un, à l'aide d'un premier film piézoélectrique polarisé dans un premier sens et, l'autre, à l'aide d'un deuxième film piézoélectrique dont la polarisation est choisie dans le sens opposé audit premier sens.

6. Procédé selon l'une quelconque des revendications précédentes, caractérisé en ce que les films métalliques sont réalisés à l'aide de feuille diélectriques (3) préalablement recouvertes de métallisations (7) sur au moins une de leurs faces, chaque métallisation (7) présentant une marge (4) non métallisée.

7. Procédé selon l'une quelconque des revendications 1 à 5, caractérisé en ce que les films métalliques sont réalisés à l'aide de feuilles entièrement métallisées.

8. Composant piézoélectrique de type empilé constitué de l'empilement d'éléments piézoélectriques (1) et d'électrodes métalliques (2), deux électrodes métalliques (2) successives encadrant un élément piézoélectrique (1) caractérisé en ce que chaque élément piézoélectrique (1) est constitué de l'empilement de p feuilles de polyfluorure de vinylidène (PVDF) ou de copolymère constitué dudit polyfluorure et de trifluoroéthylène, p étant un nombre entier supérieur ou égal à 1, ledit empilement de p feuilles étant effectué par une étape de bobinage d'un même film piézoélectrique suivant un nombre de tours égal à p, et en ce que chaque électrode métallique est constituée de l'empilement de q feuilles métalliques, q étant un nombre entier supérieur ou égal à 1, ledit empilement de q feuilles métalliques étant effectué par une autre étape de bobinage d'un même film métallique suivant un nombre de tours égal à q, chaque électrode métallique (2) présentant un débordement (d) par rapport à l'élément piézoélectrique (1) qu'elle jouxte, les débordements (d) de deux électrodes métalliques (2) insérant un même élément piézoélectrique (1) étant situés sur des côtés opposés.

9. Composant piézoélectrique selon la revendication 8, caractérisé en ce qu'il comprend sur les faces latérales dudit empilement d'éléments piézoélectriques (1) et d'électrodes métalliques des armatures métalliques (5).

10. Composant piézoélectrique de type bobiné constitué du bobinage d'éléments piézoélectriques (1) et d'électrodes métalliques (2), deux électrodes métalliques (2) successives entourant un élément piézoélectrique (1), caractérisé en ce que chaque élément piézoélectrique (1) est constitué du bobinage de p feuilles de polyfluorure de vinylidène (PVDF) ou de copolymère constitué dudit polyfluorure et de trifluoroéthylène, p étant un nombre entier supérieur ou égal à 1, et en ce que chaque électrode métallique est constitué du bobinage de q feuilles métalliques, q étant un nombre entier supérieur ou égal à 1, chaque électrode métallique (2) présentant un débordement (d) par rapport à l'élément piézoélectrique (1) qu'elle jouxte, les débordements (d) de deux électrodes métalliques (2) insérant un même élément piézoélectrique (1) étant situés sur des côtés opposés.

11. Composant piézoélectrique selon la revendication 10, caractérisé en ce qu'il comprend sur les faces latérales dudit bobinage d'éléments piézoélectriques (1) et d'électrodes métalliques des armatures métalliques (5).

12. Composant piézoélectrique selon l'une des revendications 9 ou 11, caractérisé en ce que lesdites feuilles métalliques sont des feuilles d'aluminium, de zinc ou d'un alliage d'aluminium et de zinc.

13. Composant piézoélectrique selon l'une des revendications 9 ou 11, caractérisé en ce que lesdites feuilles métalliques sont constituées d'une feuille diélectrique (3) recouverte d'une métallisation (7) sur au moins une de ses faces, chaque métallisation (7) présentant une marge (4) non métallisée.

14. Composant piézoélectrique selon la revendication 13, caractérisé en ce que ladite métallisation (7) est en aluminium.

15. Composant piézoélectrique selon l'une quelconques des revendications 9, 11, 12, 13 ou 14, caractérisé en ce que les armatures métalliques (5) sont constituées d'une couche d'aluminium, d'une couche de cuivre déposée sur ladite couche d'aluminium et d'une couche d'étain déposée sur ladite couche de cuivre.

## Patentansprüche

1. Verfahren zur Herstellung eines piezoelektrischen Bauteils, das aus der Stapelung mindestens eines piezoelektrischen Elements (1) und mindestens zweier metallbeschichteter Elektroden (2) besteht, wobei jedes piezoelektrische Element (1) zwischen zwei Metallelektroden (2) liegt, dadurch gekennzeichnet, daß es n Wickelschritte mit einer piezoelektrischen Folie, und zwar p Windungen je Schritt, und n+1 Wickelschritte mit einer metallischen Folie, und zwar q Windungen je Schritt enthält, wobei n, p und q positive ganze Zahlen sind, wobei jeder Wickelschritt mit einer piezoelektrischen Folie ein piezoelektrisches Element (1) ergibt, und jeder Wickelschritt mit der Folie eine Metallelektrode (2) ergibt und so durchgeführt wird, daß jede Metallelektrode einen Überstand (d) in Bezug auf das benachbarte piezoelektrische Element (1) aufweist, derart, daß die Überstände (d) von zwei ein piezoelektrisches Element (1) umgebenden Metallelektroden (2) sich auf entgegengesetzten Seiten befinden.

2. Verfahren nach Anspruch 1, dadurch gekennzeichnet, daß die Seitenflächen der durch die Aufwicklungen hergestellten Stapel mit einem leitenden Metall oder einer leitenden Legierung so beschichtet werden, daß sie die Anschlüsse (5) der piezoelektrischen Bauteile bilden.

3. Verfahren nach Anspruch 2, dadurch gekennzeichnet, daß die Aufwicklung der piezoelektrischen Folien (13, 14) und der Metallfolien (11, 12) auf einem Rad derart durchgeführt wird, daß ein Band gebildet wird, und daß das Band in einzelne Abschnitte zerschnitten wird, die je ein piezoelektrisches Bauteil vom Stapeltyp bilden.

4. Verfahren nach Anspruch 2, dadurch gekennzeichnet, daß die Aufwicklung der piezoelektrischen Folien (13, 14) und der Metallfolie (11, 12) ein piezoelektrisches Bauteil vom Wickeltyp bildet.

5. Verfahren nach Anspruch 3 oder 4, dadurch gekennzeichnet, daß eine von zwei aufeinanderfolgende piezoelektrischen Wicklungen (1) mit Hilfe einer ersten, in einer ersten Richtung polarisierten piezoelektrischen Folie, und die andere mit Hilfe einer zweiten in einer zur ersten Richtung entgegengesetzten Richtung polarisierten piezoelektrischen Folie hergestellt werden.

6. Verfahren nach einem beliebigen der vorhergehenden Ansprüche, dadurch gekennzeichnet, daß die Metallfolien aus dielektrischen Folien (3) hergestellt werden, die vorher mit Metallbeschichtungen (7) auf mindestens einer ihrer Flächen bedeckt werden, wobei jede Metallbeschichtung (7) einen nicht mit Metall beschichteten Seitenrand (4) aufweist.

7. Verfahren nach einem beliebigen der Ansprüche 1 bis 5, dadurch gekennzeichnet, daß die Metallfolien aus vollständig metallbeschichteten Folien hergestellt werden.

8. Piezoelektrisches Bauteil vom Stapeltyp, das aus der Stapelung von piezoelektrischen Elementen (1) und Metallelektroden (2) besteht, wobei zwei aufeinanderfolgende Metallelektroden (2) ein piezoelektrisches Element (1) einrahmen, dadurch gekennzeichnet, daß jedes piezoelektrische Element (1) aus der Stapelung von p Folien aus Polyvinylidenfluorid (PVDF) oder einem aus diesem Polyfluorid und Trifluoräthylen bestehenden Copolymer gebildet wird, wobei p eine positive ganze Zahl ist und der Stapel von p Folien durch einen Wickelschritt mit einer piezoelektrischen Folie gemäß p Windungen gebildet wird, und daß jede Metallelektrode aus der Stapelung von q Metallfolien besteht, wobei q eine positive ganze Zahl ist und der Stapel von q Metallfolien durch einen weiteren Wickel schritt mit einer Metallfolie gemäß q Windungen gebildet wird, daß jede Metallelektrode (2) einen Überstand (d) in Bezug auf das benachbarte piezoelektrische Element (1) aufweist und die Überstände (d) von zwei ein piezoelektrisches Element (1) einrahmenden Metallelektroden (2) auf entgegengesetzten Seiten liegen.

9. Piezoelektrisches Bauteil nach Anspruch 8, dadurch gekennzeichnet, daß es auf den Seitenflächen des Stapels von piezoelektrischen Elementen (1) und von Metallelektroden Metallanschlüsse (5) aufweist.

10. Spulenförmiges piezoelektrisches Bauteil vom Wickel-Typ, das aus der Aufwicklung von piezoelektrischen Elementen (1) und Metallelektroden (2) besteht, wobei zwei aufeinanderfolgende Metallelektroden (2) ein piezoelektrisches Element (1) einrahmen, dadurch gekennzeichnet, daß jedes piezoelektrische Element (1) aus der Aufwicklung von p Folien von Polyvinylidenfluorid (PVDF) oder von einem Copolymer bestehend aus dem Polyfluorid und Trifluoräthylen gebildet wird, wobei p eine positive ganze Zahl ist, daß jede Metallelektrode aus der Aufwicklung von q Metallfolien besteht, wobei q eine positive ganze Zahl ist, und jede Metallelektrode (2) einen Überstand (d) in Bezug auf das benachbarte piezoelektrische Elemente (1) aufweist, derart, daß die Überstände (d) von zwei ein piezoelektrisches Element (1) einrahmenden Metallelektroden (2) auf entgegengesetzten Seiten liegen.

11. Piezoelektrisches Bauteil nach Anspruch 10, dadurch gekennzeichnet, daß es auf den Seitenflächen des Wickels von piezoelektrischen Elementen (1) und von Metallelektroden Metallanschlüsse (5) aufweist.

12. Piezoelektrisches Bauteil nach einem der Ansprüche 9 oder 11, dadurch gekennzeichnet, daß die Metallfolien Aluminiumfolien, Zinkfolien oder Folien aus einer Legierung von Aluminium und Zink sind.

13. Piezoelektrisches Bauteil nach einem der Ansprüche 9 oder 11, dadurch gekennzeichnet, daß die Metallfolien aus einer dielektrischen Folie (3) bestehen, die auf mindestens einer ihrer Flächen mit einer Metallschicht (7) bedeckt ist, wobei jede Metallschicht (7) einen nicht mit Metall beschichteten Seitenrand aufweist.

14. Piezoelektrisches Bauteil nach Anspruch 13, dadurch gekennzeichnet, daß die Metallschicht (7) aus Aluminium ist.

15. Piezoelektrisches Bauteil nach einem beliebigen der Ansprüche 9, 11, 12, 13 oder 14, dadurch gekennzeichnet, daß die Metallanschlüsse (5) aus einer Aluminiumschicht, einer auf die Aluminiumschicht aufgebrachten Kupferschicht und einer auf die Kupferschicht aufgebrachten Zinnschicht bestehen.

## Claims

1. Process for manufacturing a piezoelectric component consisting of the stacking of at least one piezoelectric element (1) and of at least two metallic electrodes (2), each piezoelectric element (1) being inserted between two metallic electrodes (2), characterized in that it comprises n steps of coiling a piezoelectric film with, in each step, a number of turns equal to p and n+1 steps of coiling a metallic film with, in each step, a number of turns equal to q, n, p and q being integers greater than or equal to 1, each step of coiling of piezoelectric film making it possible to produce a piezoelectric element (1) and each step of coiling of metallic film making it possible to produce a metallic electrode (2), each coiling of metallic film being carried out so that each metallic electrode has an overhang (d) with respect to the piezoelectric element (1) that adjoins it, the overhangs (d) of two metallic electrodes (2) hugging the same piezoelectric element (1) being located on opposite sides.

2. Process according to Claim 1, characterized in that the lateral faces of the stacks formed by the said coiled assemblies are covered with a metal or a conducting alloy so as to form the plates (5) of the piezoelectric components.

3. Process according to Claim 2, characterized in that the piezoelectric films (13, 14) and the metallized films (11, 12) are coiled on a wheel so as to form a tape and in that the tape is cut into individual blocks each forming a piezoelectric component of the stacked type.

4. Process according to Claim 2, characterized in that the coiled assembly of the piezoelectric films (13, 14) and of the metallized films (11, 12) constitutes a piezoelectric component of the coiled type.

5. Process according to Claim 3 or 4, characterized in that two successive piezoelectric coiled assemblies (1) are produced, one using a first piezoelectric film polarized in a first direction and the other using a second piezoelectric film whose polarization is chosen in the direction opposite to the first direction.

6. Process according to any one of the preceding claims, characterized in that the metallic films are produced by using dielectric sheets (3) covered beforehand with metallizations (7) on at least one of their faces, each metallization (7) having a non-metallized margin (4).

7. Process according to any one of Claims 1 to 5, characterized in that the metallic films are produced using entirely metallized sheets.

8. Piezoelectric component of the stacked type consisting of the stack of piezoelectric elements (1) and metallic electrodes (2), two successive metallic electrodes (2) flanking a piezoelectric element (1), characterized in that each piezoelectric element (1) consists of the stack of p sheets of polyvinylidene fluoride (PVDF) or of copolymer consisting of the said vinylidene fluoride and of trifluoroethylene, p being an integer greater than or equal to 1, the said stack of p sheets being formed by a step of coiling the same piezoelectric film with a number of turns equal to p and in that each metallic electrode consists of the stack of q metallic sheets, q being an integer greater than or equal to 1, the said stack of q metallic sheets being produced by another step of coiling the same metallic film with the number of turns equal to q, each metallic electrode (2) having an overhang (d) with respect to the piezoelectric element (1) that adjoins it, the overhangs (d) of two metallic electrodes (2) hugging the same piezoelectric element (1) being located on opposite sides.

9. Piezoelectric component according to Claim 8, characterized in that it comprises metallic plates (5) on the side faces of the said stack of piezoelectric elements (1) and of metallic electrodes.

10. Piezoelectric component of the coiled type consisting of the coiled assembly of piezoelectric elements (1) and of metallic electrodes (2), two successive metallic electrodes (2) surrounding a piezoelectric element (1), characterized in that each piezoelectric element (1) consists of the coiled assembly of p sheets of polyvinylidene fluoride (PVDF) or copolymer consisting of the said vinylidene fluoride and of trifluoroethylene, p being an integer greater than or equal to 1, and in that each metallic electrode consists of the coiled assembly of q metallic sheets, q being an integer greater than or equal to 1, each metallic electrode (2) having an overhang (d) with respect to the piezoelectric element (1) that adjoins it, the overhangs (d) of two metallic electrodes (2) hugging the same piezoelectric element (1) being located on opposite sides.

11. Piezoelectric component according to Claim 10, characterized in that it comprises metallic plates (5) on the lateral faces of the said coiled assembly of piezoelectric elements (1) and of metallic electrodes.

12. Piezoelectric component according to either of Claims 9 and 11, characterized in that the said metallic sheets are aluminium foils, zinc foils or foils of an alloy of aluminium and zinc.

13. Piezoelectric component according to either of Claims 9 and 11, characterized in that the said metallic sheets consist of a dielectric sheet (3) covered with a metallization (7) on at least one of its faces, each metallization (7) having a non-metallized margin (4).

14. Piezoelectric component according to Claim 13, characterized in that the said metallization (7) is made of aluminium.

15. Piezoelectric component according to any one of Claims 9, 11, 12, 13 and 14, characterized in that the metallic plates (5) are formed by a layer of aluminium, by a layer of copper deposited on the said layer of aluminium and by a layer of tin deposited on the said layer of copper.
